# EUROPEAN PATENT APPLICATION

(11) **EP 2 056 341 A2**
(43) Date of publication of application: **06.05.2009**
(21) Application number: 08168110.8
(22) Date of filing: 31.10.2008
(51) Int. Cl.: H01L 21/311

(54) **Methods for forming high aspect ratio features on a substrate**

(30) Priority: 02.11.2007 US 934589
(71) Applicant: Applied Materials, Inc., Santa Clara, CA 95054 (US)
(72) Inventor: Doan, Kenny Lihn, San Jose, CA 95131 (US); Keswick, Kathryn, San Jose, CA 95112 (US); Deshmukh, Subhash, San Jose, CA 95138 (US); Wege, Stephan, 01328, Dresden (DE); Lee, Wonseok, Pleasanton, CA 94588 (US)
(74) Representative: Zimmermann & Partner

(57) **Abstract**

Methods for forming anisotropic features for high aspect ratio application in etch process are provided. The methods described herein advantageously facilitates profile and dimension control of features with high aspect ratios. In one embodiment, a method for anisotropic etching a dielectric layer on a substrate includes providing a substrate having a patterned mask layer disposed on a dielectric layer in an etch chamber, supplying a gas mixture including at least a fluorine and carbon containing gas and a silicon fluorine gas into the etch chamber, and etching features in the dielectric layer in the presence of a plasma formed from the gas mixture.

## Description

### BACKGROUND

### Field of the Invention

The present invention generally relates to methods for forming high aspect ratio features on a substrate. More specifically, the present invention generally relates to methods for forming high aspect ratio features by an anisotropic etch process in semiconductor manufacture. Further, the present invention relates to a method for anisotropic etching a dielectric layer on a substrate with high aspect ratios.

### Description of the Related Art

Reliably producing sub-half micron and smaller features is one of the key technologies for the next generation of very large scale integration (VLSI) and ultra large-scale integration (ULSI) of semiconductor devices. However, as the limits of integrated circuit technology are pushed, the shrinking dimensions of interconnects in VLSI and ULSI technology have placed additional demands on processing capabilities. Integrated circuits may include more than one million micro-electronic field effect transistors (*e.g*., complementary metal-oxide-semiconductor (CMOS) field effect transistors) that are formed on a substrate (e.g., semiconductor wafer) and cooperate to perform various functions within the circuit. Reliable formation of the gate pattern is important to integrated circuits success and to the continued effort to increase circuit density and quality of individual substrates and die.

As feature sizes have become smaller, the demand for higher aspect ratios, defined as the ratio between the depth of the feature and the width of the feature, has steadily increased to 20:1 and even greater. Developing etch processes that are capable of reliably forming features with such high aspect ratios presents a significant challenge.

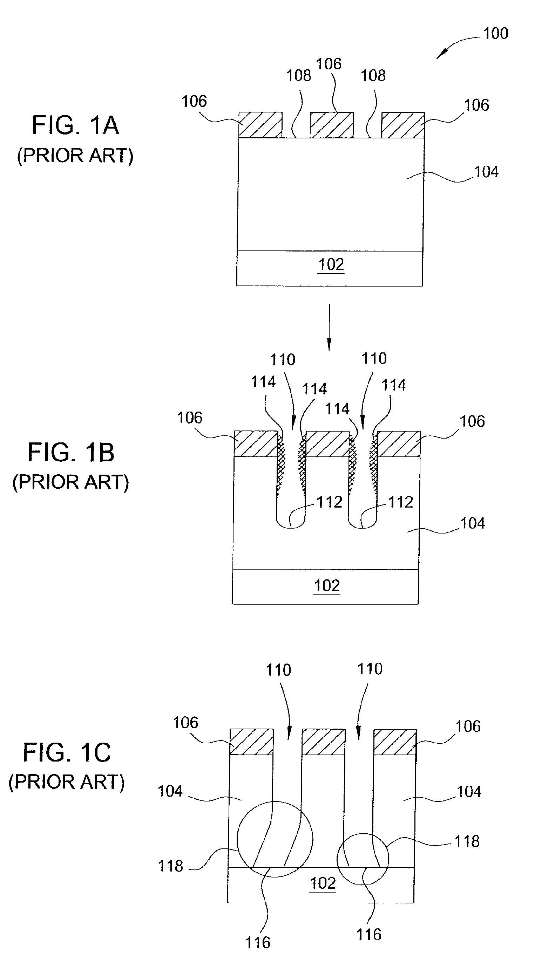

Traditionally, features having aspect ratios of about 10:1 or so were fabricated by anisotropically etching dielectric layers to a predetermined depth and width. For example, Figure 1A depicts a substrate 102 having portions of a dielectric layer 104 exposed through openings 108 formed through a patterned mask layer 106. During etching, redeposition or build-up of by-products or other materials 114 generated during the etching process may accumulate on the top and/or sidewalls of the features 110 being etched, thereby blocking the opening 108 in the mask 106 and the feature 110 being formed in the dielectric layer 104, as shown in Figure 1B. As the opening 108 of the etched features 110 are narrowed and/or sealed by the accumulated redeposition material 114, the reactive etchants are prevented from reaching the lower surface 112 of the features 110, thereby limiting the aspect ratio that may be obtained. Additionally, as the redeposition material or build-up of by-products may be randomly and/or irregularly adhere to the top surface and/or sidewalls of the dielectric layer 104, the resulting irregular profile and growth of the redeposition material 114 may alter the flow path of the reactive etchants, thereby resulting in a bowing or twisting profile 118 of the features 110 formed in the dielectric layer 104, as shown in Figure 1C.

Therefore, there is a need in the art for improved methods for etching features with high aspect ratios.

### SUMMARY

Methods for forming high aspect ratio features using an etch process are provided. The methods described herein advantageously facilitates profile and dimension control of features with high aspect ratios through a conductive sidewall management scheme during etching.

In light of the above, the method according to independent claim 1, the method according to independent claim 10, and the method according to claim 14 are provided.

Further advantages, features, aspects and details are evident from the dependent claims, the description and the drawings.

In one embodiment, the method for anisotropic etching a dielectric layer on a substrate may include providing a substrate having a patterned mask layer disposed on a dielectric layer in an etch chamber, supplying a gas mixture including at least a fluorine and carbon containing gas and a silicon fluorine gas into the etch chamber, and etching features in the dielectric layer in the presence of a plasma formed from the gas mixture.

In another embodiment, a method for anisotropic etching a dielectric layer on a substrate may include providing a substrate having a patterned amorphous carbon layer disposed on a dielectric layer into an etch chamber, supplying a gas mixture including at least a fluorine and carbon containing gas and a silicon fluorine gas into the etch chamber, and etching features to an aspect ratio greater than about 20:1 in the presence of a plasma formed from the gas mixture through openings in the amorphous carbon layer.

In yet another embodiment, a method for anisotropic etching a dielectric layer on a substrate may include providing a substrate having a patterned amorphous carbon layer disposed on a dielectric layer into an etch chamber, supplying a gas mixture including at least a fluorine and carbon containing gas and a silicon fluorine gas into the etch chamber, etching features to an aspect ratio greater than about 20:1 in the dielectric layer by a plasma formed from the gas mixture, forming a conductive polymer layer on surfaces of the features while etching, and configuring the features as a contact structure for field effect transistors.

Further, methods for forming anisotropic features for high aspect ratio application in etch process are provided. The methods described herein advantageously facilitates profile and dimension control of features with high aspect ratios. In one embodiment, a method for anisotropic etching a dielectric layer on a substrate includes providing a substrate having a patterned mask layer disposed on a dielectric layer in an etch chamber, supplying a gas mixture including at least a fluorine and carbon containing gas and a silicon fluorine gas into the etch chamber, and etching features in the dielectric layer in the presence of a plasma formed from the gas mixture.

In another embodiment a dielectric layer on a substrate is provided, the dielectric layer having high aspect ratios. In particular the aspect ratio is greater than about 20:1.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

The teachings of the present invention can be readily understood by considering the following detailed description in conjunction with the accompanying drawings, in which:

Figure 1A-1C illustrate cross-sectional views of a conventional fabrication sequence used to fabricate a high aspect ratio feature;

Figure 2 is a schematic diagram of a plasma processing apparatus which may be utilized to perform an etching process according to at least one embodiment of the invention;

Figure 3 is a process flow diagram of a method suitable for fabricating high aspect ratio features according to at least one embodiment of the invention;

Figures 4A-4C are sequential cross-sectional views of a composite structure etched to form high aspect ratio features according to the method of Figure 3; and

Figures 5 is a cross-sectional view of a composite structure having high aspect ratio features formed by the present invention in a contact structure for field effect transistors.

To facilitate understanding, identical reference numerals have been used, where possible, to designate identical elements that are common to the figures. It is contemplated that elements and features of one embodiment may be beneficially incorporated in other embodiments without further recitation.

It is to be noted, however, that the appended drawings illustrate only exemplary embodiments of this invention and are therefore not to be considered limiting of its scope, for the invention may admit to other equally effective embodiments.

### DETAILED DESCRIPTION

The invention generally relates to methods for forming features having high aspect ratios using an etch process. In one embodiment, the method includes plasma etching a dielectric layer using an etching gas mixture of a silicon fluorine gas and a fluorine and carbon based gas. The silicon fluorine gas of the etching gas mixture forms a conductive polymer layer on the sidewalls and/or surfaces of the etched dielectric layer, thereby extending ion trajectories in the deep features during etching. The extended ion trajectories assist etching the dielectric layer down to the bottom of the dielectric layer, thereby forming features with desired high aspect ratios while retaining good profile control and critical dimensions.

The etch process described herein may be performed in any plasma etch chamber, for example, a HART etch reactor, a HART TS etch reactor, a Decoupled Plasma Source (DPS), DPS-II, or DPS Plus, or DPS DT etch reactor of a CENTURA^{®} etch system, all of which are available from Applied Materials, Inc. of Santa Clara, California. Suitable plasma etch chambers available from other manufacturers may also be utilized.

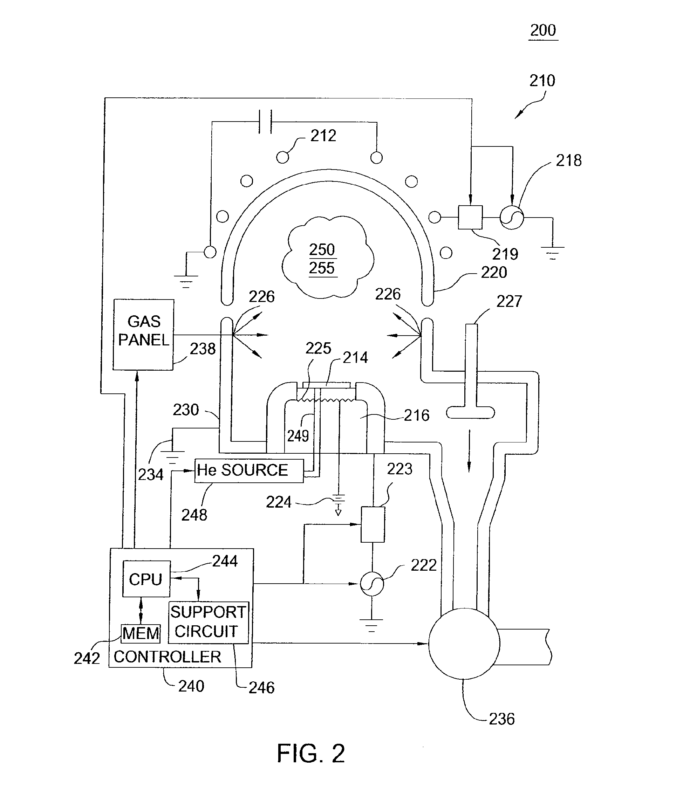

Figure 2 depicts a schematic diagram of one embodiment of an etch process chamber 200. The chamber 200 includes a conductive chamber wall 230 that supports a dielectric dome-shaped ceiling (referred hereinafter as the dome 220). Other chambers may have other types of ceilings (e.g., a flat ceiling). The wall 230 is connected to an electrical ground 234.

At least one inductive coil antenna segment 212 is coupled to a radio-frequency (RF) source 218 through a matching network 219. The antenna segment 212 is positioned exterior to the dome 220 and is utilized to maintain a plasma formed from process gases within the chamber. In one embodiment, the source RF power applied to the inductive coil antenna 212 is in a range between about 0 Watts to about 2500 Watts at a frequency between about 50 kHz and about 13.56 MHz. In another embodiment, the source RF power applied to the inductive coil antenna 212 is in a range between about 200 Watts to about 800 Watts, such as at about 400 Watts.

The process chamber 200 also includes a substrate support pedestal 216 (biasing element) that is coupled to a second (biasing) RF source 222 that is generally capable of producing an RF signal to generate a bias power about 1500 Watts or less (e.g., no bias power) at a frequency of approximately 13.56 MHz. The biasing source 222 is coupled to the substrate support pedestal 216 through a matching network 223. The bias power applied to the substrate support pedestal 216 may be DC or RF.

In operation, a substrate 214 is placed on the substrate support pedestal 216 and is retained thereon by conventional techniques, such as electrostatic chucking or mechanical clamping of the substrate 214. Gaseous components are supplied from a gas panel 238 to the process chamber 200 through entry ports 226 to form a gaseous mixture 250. A plasma, formed from the mixture 250, is maintained in the process chamber 200 by applying RF power from the RF sources 218 and 222, respectively, to the antenna 212 and the substrate support pedestal 216. The pressure within the interior of the etch chamber 200 is controlled using a throttle valve 227 situated between the chamber 200 and a vacuum pump 236. The temperature at the surface of the chamber walls 230 is controlled using liquid-containing conduits (not shown) that are located in the walls 230 of the chamber 200.

The temperature of the substrate 214 is controlled by stabilizing the temperature of the support pedestal 216 and flowing a heat transfer gas from source 248 via conduit 249 to channels formed by the back of the substrate 214 and grooves (not shown) on the pedestal surface. Helium gas may be used as the heat transfer gas to facilitate heat transfer between the substrate support pedestal 216 and the substrate 214. During the etch process, the substrate 214 is heated by a resistive heater 225 disposed within the substrate support pedestal 216 to a steady state temperature via a DC power source 224. Helium disposed between the pedestal 216 and substrate 214 facilitates uniform heating of the substrate 214. Using thermal control of both the dome 220 and the substrate support pedestal 216, the substrate 214 is maintained at a temperature of between about 100 degrees Celsius and about 500 degrees Celsius.

Those skilled in the art will understand that other forms of etch chambers may be used to practice the invention. For example, chambers with remote plasma sources, microwave plasma chambers, electron cyclotron resonance (ECR) plasma chambers, and the like may be utilized to practice the invention.

A controller 240, including a central processing unit (CPU) 244, a memory 242, and support circuits 246 for the CPU 244 is coupled to the various components of the etch process chamber 200 to facilitate control of the etch process. To facilitate control of the chamber as described above, the CPU 244 may be one of any form of general purpose computer processor that can be used in an industrial setting for controlling various chambers and subprocessors. The memory 242 is coupled to the CPU 244. The memory 242, or computer-readable medium, may be one or more of readily available memory such as random access memory (RAM), read only memory (ROM), floppy disk, hard disk, or any other form of digital storage, local or remote. The support circuits 246 are coupled to the CPU 244 for supporting the processor in a conventional manner. These circuits include cache, power supplies, clock circuits, input/output circuitry and subsystems, and the like. An etching process, such as described herein, is generally stored in the memory 242 as a software routine. The software routine may also be stored and/or executed by a second CPU (not shown) that is remotely located from the hardware being controlled by the CPU 244.

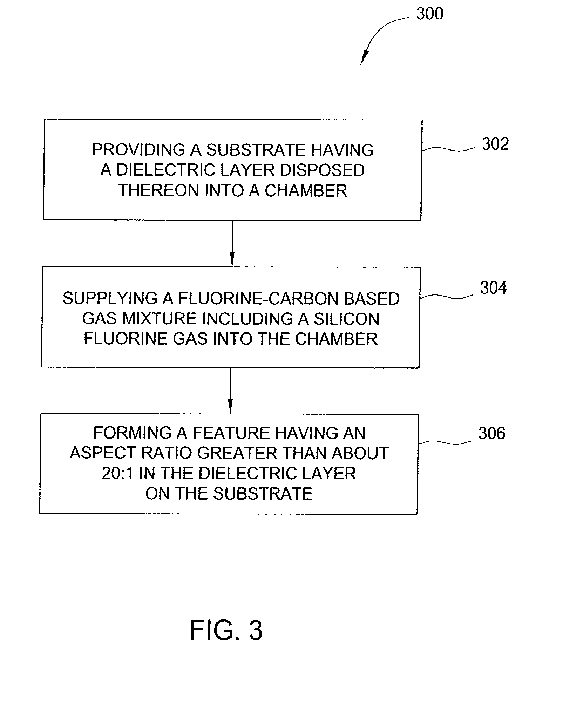

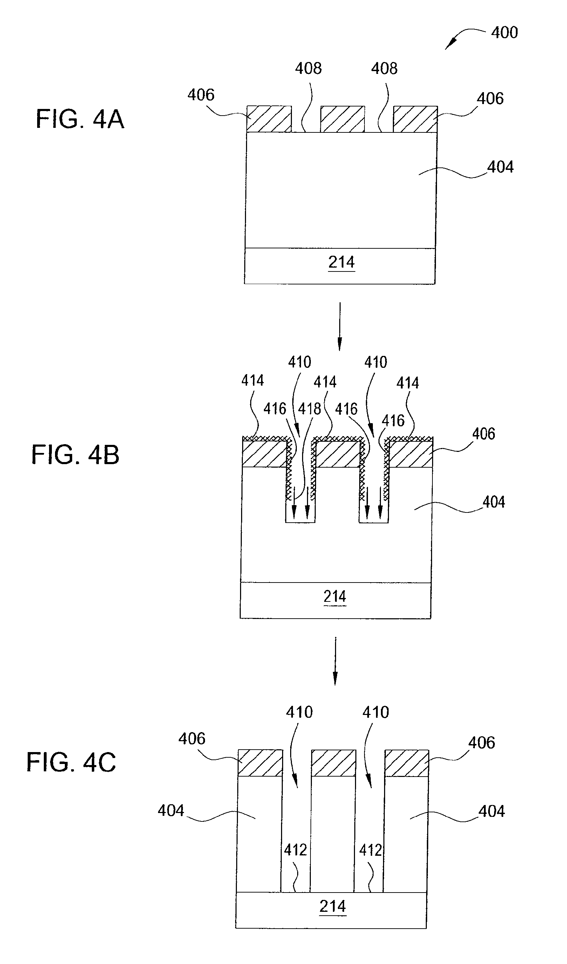

Figure 3 is a flow diagram of one embodiment of an etch process 300 that may be practiced in the chamber 200 or other suitable processing chamber. Figures 4A-4C are schematic cross-sectional views of a portion of a composite substrate corresponding to various stages of the process 300. The process 300 may be utilized to form high aspect ratio features, e.g., greater than 20:1, for structures, such as a contact structure for field effect transistors. Alternatively, the process 300 may be beneficially utilized to etch other types of structures.

The process 300 begins at block 302 by transferring (*i.e.,* providing) a substrate 214 to an etch process chamber, such as the etch chamber 200 depicted in Figure 2. In the embodiment depicted in Figure 4A, the substrate 214 has a film stack 400 having a patterned mask layer 406 disposed on a dielectric layer 404. The patterned mask layer 406 has openings 408 that expose portions of the underlying dielectric layer 404 for etching. The substrate 214 may be any one of semiconductor substrates, silicon wafers, glass substrates and the like.

In one embodiment, the mask layer 406 may be a hard mask, a photoresist mask or a combination thereof. The mask layer 406 is used as an etch mask to etch features 410 in the dielectric layer 404 with desired aspect ratios. The features 410 described herein may include trenches, vias, openings and the like. In one embodiment, the mask layer 406 may be a material selected from a group consisting of silicon, silicon oxide, silicon nitride, silicon oxynitride, silicon carbide, amorphous carbon, and combinations thereof. In an exemplary embodiment depicted herein, the mask layer 406 is an amorphous carbon layer. One example of the amorphous carbon layer may be an Advanced Patterning Film^{™} (APF) available from Applied Materials, Inc. The dielectric layer 404 may be a dielectric oxide layer. Other suitable materials for the dielectric layer include undoped silicon glass (USG), such as silicon oxide or TEOS, boron-silicate glass (BSG), phosphorus-silicate glass (PSG), boron-phosphorus-silicate glass (BPSG) and combinations thereof. In an exemplary embodiment depicted herein, the dielectric layer 404 is an undoped silicon glass (USG) layer. In one embodiment, the dielectric layer 404 has a thickness between about 3000 Å to about 15000 A, such as between about 4000 Å to about 12000 Å, for example about 10000 Å.

At block 304, a gas mixture that includes a fluorine and carbon based gas and a silicon fluorine gas is supplied to the etch chamber to anisotropically etch the substrate 214 placed therein. During etching, fluorine and carbon gas and silicon fluorine gas are dissociated as reactive etchant species by a plasma formed from the gas mixture. The silicon ions from the silicon fluorine gas react with a portion of the carbon ions from the fluorine and carbon gas in the gas mixture, forming a conductive silicon containing polymer on the etched surface, e.g., sidewalls, of features 410 etched in the dielectric layer 404, as shown in Figure 4B. As the silicon ions may provide more electrons during etching than carbon based polymers conventionally used to protect the etched surface, e.g., sidewalls, of the dielectric layer 404, the conductive properties of the silicon containing polymer 416 assists an electron transfer process occurring during the etch reaction. The conductive silicon containing polymer 416 conducts the ions and/or electrons to the deeper portions of the features 410, as shown by arrows 418. The conductive polymer layer 416 also reduces charge built-up and growth into the features 410 of the dielectric layer 404, thereby preventing the features being closed, narrowed, bowed or further disrupting the etching process. The conductive silicon containing polymer 416 improves the ion trajectories in the etched features 410, thereby facilitating the formation of features 410 with high aspect ratios deep in the dielectric layer 404.

During etching, the mask layer 406 may also be attacked by the fluorine ions from the supplied gas mixture. As such, by adding the silicon fluorine gas into the fluorine and carbon based gas mixture, the silicon ions from the silicon fluorine gas may efficiently react with the mask layer 406 to form a strong protection layer 414 on the upper surface of the mask layer 406. In the embodiment wherein the mask layer 406 is an amorphous carbon layer, the silicon ions react with the carbon elements in the mask layer 406, thereby forming a robust silicon carbide layer on the upper surface of the mask layer 406, thus protecting the mask layer 406 from being attacked during the high aspect ratio features 410 forming process.

In one embodiment, the silicon fluorine gas supplied in the gas mixture may be selected from a group consisting of SiF₄, SiCl₄ and the like. The fluorine and carbon gas supplied in the gas mixture is selected from a group consisting of CF₄, CHF₃, C₄F₈, C₂F₆, C₄F₆, C₅F₈, CH₂F₂ and the like. An inert gas may be optionally supplied with the gas mixture to assist carrying the gas mixture into the etch chamber. Suitable examples of the inert gas include N₂, Ar, He, and Kr gas.

Several process parameters are regulated while the gas mixture supplied into the etch chamber. In one embodiment, the chamber pressure is regulated between about 10 mTorr to about 60 mTorr, for example, at about 20 mTorr. RF source power may be applied to maintain a plasma formed from the first process gas. For example, a power of about 200 Watts to about 1000 Watts may be applied to an inductively coupled antenna source to maintain a plasma inside the etch chamber. The fluorine and carbon gas may be flowed into the chamber at a rate between about 20 sccm to about 100 sccm. The silicon fluorine gas may be flowed into the chamber at a rate between about 10 sccm to about 50 ccm. The inert gas may be flowed into the chamber at a rate between about 200 sccm to about 1000 sccm. A substrate temperature is maintained between about 20 degrees Celsius to about 80 degrees Celsius.

Additionally, the ratio of the fluorine and carbon gas to the silicon fluorine gas supplied in the gas mixture may be controlled. In one embodiment, the gas ratio of the fluorine and carbon gas to the silicon fluorine gas is controlled between about 1:0.15 to about 1:0.5, for example, about 1:0.25.

At block 306, an endpoint of the etching process is determined by any suitable method as one feature 410 reaches a desired depth, an optional underlying layer and/or the substrate 214. For example, the endpoint may be determined by monitoring optical emissions, expiration of a predefined time period or by another indicator for determining that the layer being etched has been sufficiently removed.

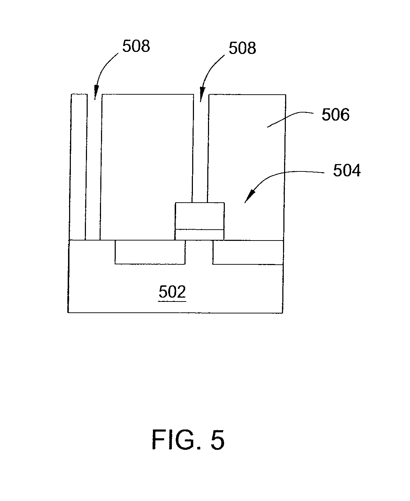

As shown in Figure 4C, the features 410 with a desired high aspect ratio are formed on the substrate 214. In one embodiment, the features 410 formed on the substrate 214 have an aspect ratio greater than about 20:1. In one embodiment, the process 300 may be utilized to form a contact structure having features 410 with aspect ratios greater than about 20:1 formed in a dielectric layer 404 as a contact structure disposed on field effect transistors 504 on a substrate 502, as shown in Figure 5. The features 410 may be filled or deposited with metal materials to form interconnection structure on the substrate. Examples of metal materials include tungsten (W), tungsten nitride (WN), copper (Cu), titanium (Ti), tantalum (Ta), aluminum (Al) or the like. Alternatively, the process 300 may be used to manufacture other structures used to fabricate integrated circuits.

Thus, the present application provides an improved method for etching a substrate to form features with aspect ratios greater than 20:1. The method advantageously using a fluorine and carbon based gas mixture along with an addition of silicon fluorine gas to form conductive polymer layer during etching, thereby efficiently providing good profile and dimension control of the features with high aspect ratios formed on a substrate.

While the foregoing is directed to embodiments of the present invention, other and further embodiments of the invention may be devised without departing from the basic scope thereof, and the scope thereof is determined by the claims that follow.

## Claims

1. A method for anisotropic etching a dielectric layer on a substrate with high aspect ratios, comprising:
providing a substrate having a patterned mask layer disposed on a dielectric layer in an etch chamber;
supplying a gas mixture including at least a fluorine and carbon containing gas and a silicon fluorine gas into the etch chamber; and
etching features in the dielectric layer in the presence of a plasma formed from the gas mixture.

2. The method of claim 1, wherein the dielectric layer is selected from a group consisting of undoped silicon glass (USG), boron-silicate glass (BSG), phosphorus-silicate glass (PSG), boron-phosphorus-silicate glass (BPSG) and combinations thereof.

3. The method of claims 1 or 2, wherein the patterned mask layer is selected from a group consisting of silicon, silicon oxide, silicon nitride, silicon oxynitride, silicon carbide, amorphous carbon and combinations thereof.

4. The method of one of the claims 1 to 3, wherein supplying the gas mixture further comprises:
forming a conductive polymer layer on the etched surface of the dielectric layer.

5. The method of claim 4, wherein the conductive polymer layer is a silicon containing polymer.

6. The method of claim 4 or 5, wherein the conductive polymer layer assists conducting ions generated from the plasma for anisotropic etching the dielectric layer down toward a bottom of the dielectric layer.

7. The method of one of the claims 1 to 6, wherein the fluorine and carbon containing gas and the silicon fluorine gas are SiF₄ and SiCl₄.

8. The method of one of the claims 1 to 7, wherein the fluorine and carbon containing gas is selected from a group consisting of CF₄, CHF₃, C₄F₈, C₂F₆, C₄F₆, C₅F₈ and CH₂F₂.

9. The method of one of the claims 1 to 8, wherein supplying the gas mixture further comprises:
supplying the fluorine and carbon containing gas at a flow rate between about 20 sccm and about 100 sccm;
supplying the silicon fluorine gas at a flow rate between about 10 sccm and about 50 sccm;
maintaining a process pressure at between about 10 mTorr to about 60 mTorr;
controlling substrate temperature between about 20 degrees Celsius to about 80 degrees Celsius; and
applying a plasma power of between about 200 Watts to about 1000 Watts.

10. A method for anisotropic etching a dielectric layer on a substrate with high aspect ratios, comprising.
providing a substrate having a patterned amorphous carbon layer disposed on a dielectric layer into an etch chamber;
supplying a gas mixture including at least a fluorine and carbon containing gas and a silicon fluorine gas into the etch chamber; and
etching features to an aspect ratio greater than about 20:1 in the presence of a plasma formed from the gas mixture through openings in the amorphous carbon layer.

11. The method of claim 10, wherein supplying the gas mixture further comprises:
forming a conductive polymer layer on the etched surface of the dielectric layer.

12. The method of claim 11, further comprising:
reacting the silicon elements provided by the silicon fluorine gas with the amorphous carbon layer to form a protection layer.

13. The method of claim 11 or 12, wherein supplying the gas mixture further comprises:
supplying an inert gas with the gas mixture into the etch chamber, wherein the inert gas is selected from a group consisting of N₂, Ar, He, and Kr.

14. A method for anisotropic etching a dielectric layer on a substrate with high aspect ratios, comprising:
providing a substrate having a patterned amorphous carbon layer disposed on a dielectric layer into an etch chamber;
supplying a gas mixture including at least a fluorine and carbon containing gas and a silicon fluorine gas into the etch chamber;
etching features to an aspect ratio greater than about 20:1 in the dielectric layer by a plasma formed from the gas mixture;
forming a conductive polymer layer on surfaces of the features while etching; and
configuring the features as a contact structure for field effect transistors.

15. The method of claim 14, wherein the dielectric layer is selected from a group consisting of silicon oxide, boron-silicate glass (BSG), phosphorus-silicate glass (PSG), boron-phosphorus-silicate glass (BPSG) and combinations thereof.
